# EUROPEAN PATENT APPLICATION

(11) **EP 2 667 220 A1**
(43) Date of publication of application: **27.11.2013**
(21) Application number: 13275126.4
(22) Date of filing: 28.05.2013
(51) Int. Cl.: G01S 13/93, G01S 13/34

(54) **Vehicle-borne radar systems with continuous-time, sigma delta analog-to-digital converters, and methods of their operation**

(30) Priority: 25.05.2012 US 201213480977
(71) Applicant: Freescale Semiconductor, Inc., Austin, TX 78735 (US)
(72) Inventor: Braswell, Brandt, Chandler, AZ Arizona 85249 (US); Garrity, Douglas A., Gilbert, AZ Arizona 85233 (US); Kabir, Mohammad Nizam U., Tempe, AZ Arizona 85283 (US)
(74) Representative: Wray, Antony John

(57) **Abstract**

Embodiments of vehicle-borne radar systems (202) and methods of their operation are provided. The vehicle-borne radar system (202) includes a transmit path (210) and a first receive path (220). The transmit path is capable of producing (502) a signal for transmission over an air interface (e.g., a frequency modulated continuous wave (FMCW) signal). The receive path includes a continuous-time (CT) sigma delta analog-to-digital converter (ADC) (228), and the receive path is capable of receiving (504) a reflected version of the signal from the air interface, and converting the reflected version along the receive path into a sequence of digital samples using the CT sigma delta ADC. In an embodiment, the transmit path and the receive path are integrated onto a single integrated circuit.

## Description

### TECHNICAL FIELD

Embodiments relate generally to vehicle-borne radar systems that include analog-to-digital converters, and methods of their operation.

### BACKGROUND

Radar systems increasingly have been incorporated into vehicles for a variety of purposes. A typical vehicle-borne radar system includes a transmit path configured to transmit a signal consisting of electromagnetic pulses (e.g., radio waves or microwaves) over an air interface, and a receive path configured to receive versions of the signal that have reflected back from objects in proximity to the vehicle. The receive path downconverts and digitizes the received signal for analysis by a digital signal processor, which may use the information from the receive path to determine ranges, altitudes, directions, and/or relative velocities of objects external to the vehicle.

Often in vehicle-borne radar systems, a pipeline or alternative discrete time nyquist rate analog-to-digital converter (ADC) is used in the receive path to perform the analog-to-digital conversion of the received (reflected) and downconverted signals. A pipeline ADC is configured to perform a coarse conversion of an analog input signal, and subsequently to perform one or more additional steps of sub-ranging in order to generate a digital sample of the input signal at a given sampling instant. In order to avoid aliasing in conjunction with the sampling process, the receive path of a radar system that employs a pipeline ADC architecture includes an anti-aliasing filter at the input to the pipeline ADC. For such an application, the anti-aliasing filter may require a significant number of filtering poles, each of which may be implemented, for example, using an active resistor-capacitor (RC) network (e.g., an operational amplifier, a pair of resistors, and a pair of capacitors). Accordingly, in a typical example system in which 12 poles of filtering are implemented, an anti-aliasing filter may include 12 operational amplifiers, 24 resistors, and 24 capacitors.

Although pipeline ADCs are adequate for some applications, pipeline ADCs have various disadvantages that may make them unsuitable or non-optimal for other applications. For example, in order to achieve adequate performance, the anti-aliasing filter associated with the pipeline ADC may be relatively large and expensive. In addition, the active RC filter configuration may produce a significant amount of noise, and thus the anti-aliasing filter and pipeline ADC should be properly isolated from other system components that otherwise may suffer from the interference. Further, a pipeline ADC tends to consume a large amount of power. Accordingly, vehicle-borne radar systems that overcome at least some of these disadvantages are desired.

### BRIEF DESCRIPTION OF THE DRAWINGS

FIG. 1 is a simplified diagram depicting an automobile with an automobile radar system, in accordance with an example embodiment;

FIG. 2 is a simplified block diagram of a vehicle-borne radar module that includes a continuous-time (CT) sigma delta analog-to-digital converter (ADC) configuration, according to an example embodiment;

FIG. 3 is a simplified schematic of a second order CT sigma delta ADC with a feedback topology, which may be used in the system of FIG. 2, according to an example embodiment;

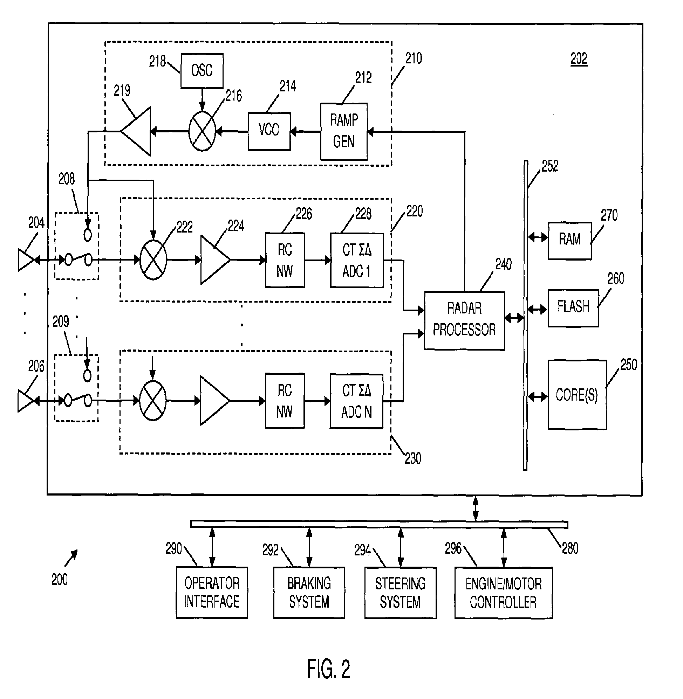

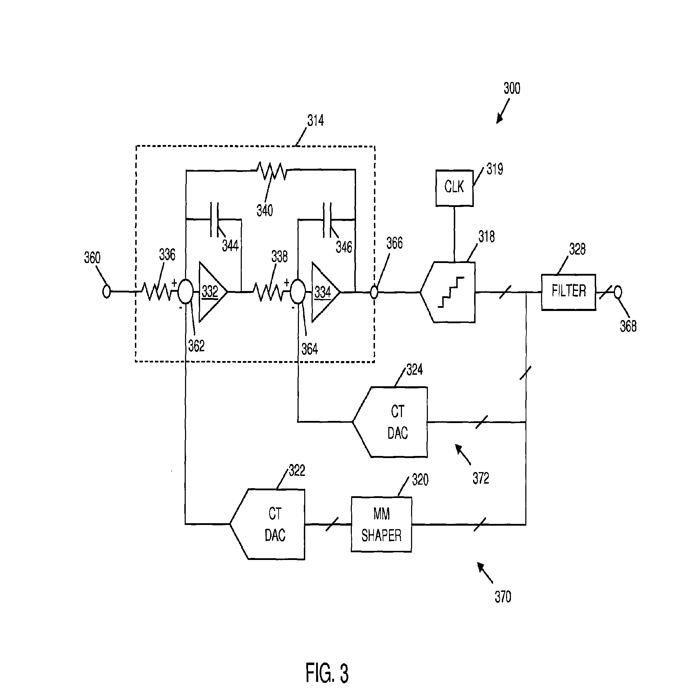

FIG. 3 is a simplified schematic of a third order CT sigma delta ADC with a feed-forward topology, which may be used in the system of FIG. 2, according to an example embodiment; and

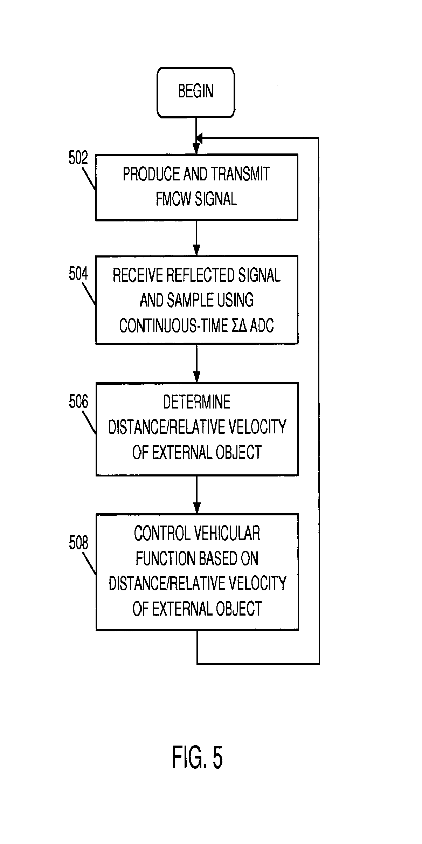

FIG. 5 is a flowchart of a method for operating a vehicle-borne radar system with a CT sigma delta ADC in the receive path, according to an example embodiment.

### DETAILED DESCRIPTION

Embodiments described herein include vehicle-borne radar systems with continuous-time (CT) sigma delta analog-to-digital converters (ADCs) in their receive paths. In an embodiment, a radar system is configured as a frequency modulated continuous wave (FMCW) radar system that transmits a FMCW millimeter wave signal over an air interface, receives reflected versions of the FMCW signal, and compares differences between the transmitted and received versions in order to determine ranges, altitudes, directions, and/or relative velocities of objects external to the vehicle. Although embodiments may be used in a variety of vehicle types (e.g., automobiles, boats/ships, aircraft, spacecraft, and so on), example embodiments employed in automobiles are discussed in detail below. The example embodiments are not meant to limit application of the inventive subject matter only to automobiles, as the embodiments may be incorporated into other types of vehicles, as well.

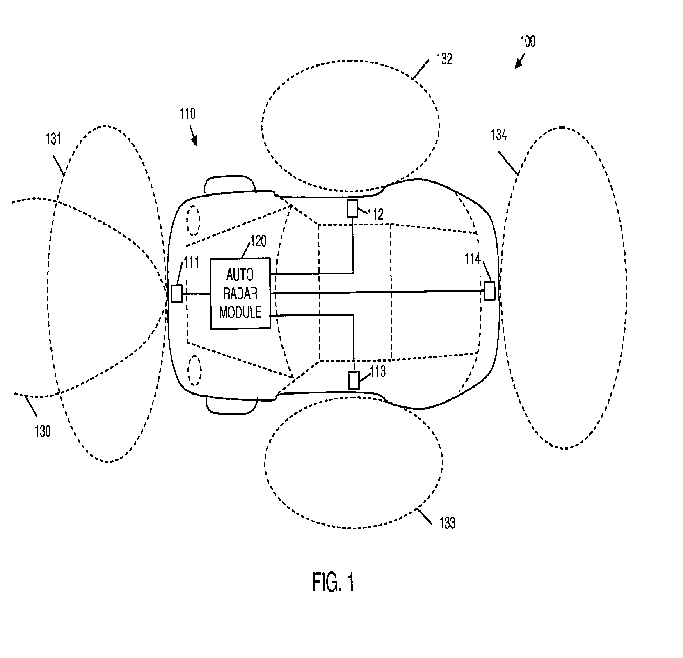

FIG. 1 is a simplified diagram depicting an automobile 100 that includes an automobile radar system 110, in accordance with an example embodiment. The automobile radar system 110 includes an automobile (auto) radar module 120 and one or more antennas 111, 112, 113, 114 positioned at various locations with respect to the body of the automobile 100. Each antenna 111-114 may be configured both to transmit and receive electromagnetic signals (e.g., to transmit FMCW microwave signals and to receive reflected versions of those signals), in an embodiment. In alternate embodiments, a system may include distinct transmit and receive antennas, where one or more of the antennas transmits the electromagnetic signals (e.g., FMCW microwave signals), and one or more other antennas receives reflected versions of the transmitted signals. Either way, each of the antennas 111-114 is electrically coupled with the auto radar module 120.

As will be explained in more detail in conjunction with FIG. 2, the auto radar module 120 includes, at least, a transmit path (e.g., transmit path 210, FIG. 2), one or more receive paths (e.g., receive paths 220, 221, FIG. 2), and a digital signal processor (DSP) (e.g., DSP 230, FIG. 2). The auto radar module 120 is responsible for coordinating transmission of electromagnetic signals via antennas 111-114, receiving analog representations of signals detected by antennas 111-114, digitizing the received signals, and processing the digitized signals to determine ranges, altitudes, directions, and/or relative velocities of objects external to the automobile 100.

The position, orientation, and physical configuration of each antenna 111-114 with respect to the body of the automobile 100 defines, at least in part, a range 130, 131, 132, 133, 134 within which each antenna 111-114 may reliably detect reflections from external objects. The automobile radar system 110 may be configured so that the ranges 130-134 are relatively "short" (e.g., ranges 131-134) and/or relatively "long" (e.g., range 130), depending on the applications for which object detection is desired. For example, when the automobile radar system 110 is used to provide object range, direction, and velocity information to an adaptive cruise control system, the automobile radar system 110 may be configured to provide a relatively long ranges of detection directed in front of and/or behind the vehicle (e.g., range 130). Conversely, when the automobile radar system 110 is used to provide object range, direction, and velocity information for a collision sensing and warning system, a vehicle parking or backing system, and/or a blind spot detection system, the automobile radar system 110 may be configured to provide a relatively short range of detection directed in front of, behind, and/or to the sides of the vehicle (e.g., ranges 131-134). Although four antennas 111-114 at four particular locations are illustrated in FIG. 1, an automobile radar system may include more or fewer antennas at more, fewer, and/or different locations with respect to the body of an automobile.

As suggested above, the information produced by the automobile radar system 110 may be provided to other processing components and/or subsystems (not illustrated), which may coordinate various actions based on the information. For example, the information may be consumed by an adaptive cruise control system (not illustrated), which, while the automobile 100 is in a cruise control mode, may initiate vehicle braking and/or engine output power adjustments based on the information in an attempt to maintain desired distances between the automobile 100 and other vehicles traveling along the same path (either in front of or behind the automobile 100). Conversely, the information from the automobile radar system 110 may be consumed by a collision sensing and avoidance system, which may provide operator warnings and/or initiate vehicle braking, engine output power adjustments, and/or steering adjustments based on the information in an attempt to avoid a collision or reduce its severity. Similarly, the information from the automobile radar system 110 may be consumed by a vehicle parking or backing system, and/or a blind spot detection system, each of which may provide operator warnings and/or initiate vehicle braking, engine output power adjustments, and/or steering adjustments based on the information.

FIG. 2 is a simplified block diagram of a vehicle-borne system 200 that includes a radar module 202 with a CT sigma delta ADC 228 in its receiver lineup, according to an example embodiment. For example, system 200 may be included in an automobile (e.g., automobile 100, FIG. 1), although modified versions of system 200 may be included in other types of vehicles, as well. In an automobile-borne embodiment, system 200 may include a radar module 202, an operator interface 290, a braking system 292, a steering system 294, and an engine (and/or motor) controller 296, among other things. The various components may communicate over one or more system buses 280 (e.g., a Controller Area Network (CAN) or other bus) and/or other communication means. The particular inter-communication architecture illustrated in FIG. 2 is provided for example purposes only, and is not meant to be limiting.

Although module 202 is referred to herein as a "radar module" herein, the designation is merely to indicate radar-oriented functionality that is provided by module 202 in conjunction with various embodiments. In an embodiment, module 202 may be used to perform various other functions, as well, some of which are briefly described below.

Module 202 includes a transmit path 210 and from 1 to N receive paths 220, 230, where N may be any integer (e.g., any integer from 1 to 8 or more). In addition, module 202 includes a radar processor 240, which is configured to control the production of signals by transmit path 210 and the processing of signals received via receive paths 220, 230. In an embodiment, module 202 also may include one or more core processors 250 and data storage components, such as flash memory 260 and random access memory (RAM) 270. Flash memory 260 and RAM 270 may be used to store program instructions, data, and other information that is used in conjunction with implementing various system functions. The various components of radar processor 202 may communicate over one or more internal buses (e.g., bus 252) and/or direct connections. The particular intra-communication architecture illustrated in FIG. 2 is provided for example purposes only, and is not meant to be limiting.

According to an embodiment, radar module 202 has an architecture that supports FMCW radar. More particularly, transmit path 210 is configured to generate FMCW signals, which are transmitted over an air interface by one or more antennas 204, 206. In addition, each of receive paths 220, 230 may receive a reflected version of the transmitted FMCW signal via an antenna 204, 206. In an embodiment, each of antennas 204, 206 supports both signal transmission and reception, and radar module 202 includes switches 208, 209 that selectively switch between the transmit and receive paths 210, 220, 230 to transmit and receive signals, respectively, in a periodic manner. In an alternate embodiment, separate transmit and receive antennas could be included in the system, and switches 208, 209 could be excluded. Radar processor 240 is configured to control the production of FMCW signals by transmit path 210, and to coordinate the switching of switches 208, 209 to selectively switch between the transmit path output and the receive path inputs.

Transmit path 210 includes a ramp signal generator 212, a voltage controlled oscillator (VCO) 214, an upconverter 216, and oscillator (OSC) 218, and an amplifier 219, in an embodiment. Ramp signal generator 212 produces a ramp signal, which undergoes linear transitions between first and second voltages on a periodic basis. The ramp signal is received by VCO 214, which outputs a baseband, FMCW signal having a constant velocity and a frequency that varies in response to the varying voltage of the ramp signal.

The FMCW signal produced by VCO 214 is then upconverted, by upconverter 216, to a carrier frequency that is established by oscillator 218. Accordingly, the output signal from upconverter 216 is an FMCW signal centered around the carrier frequency. For example, in a system that produces an FMCW signal having +/- 500 megahertz (MHz) frequency variation and a carrier signal having a frequency of 77 gigahertz (GHz), the upconverted FMCW signal produced by upconverter 216 may vary between 76.5 GHz and 77.5 GHz. Other carrier frequencies and frequency variations also could be used in the same system (e.g., to provide short range radar (SRR) or long range radar (LRR) by the same system), or could be used in other systems.

The upconverted FMCW signal produced by oscillator 218 is amplified by amplifier 219. The amplified FMCW signal is then provided to switches 208, 209 and, ultimately, to antennas 204, 206 for radiation in the form of electromagnetic waves over the air interface. Once transmitted, the FMCW signals may be reflected back toward antennas 204, 206 by objects within range of the antennas 204, 206.

Signals detected by antennas 204, 206 are provided by switches 208, 209 to their respective receive paths 220, 230. The components and functioning of receive paths 220, 230 are essentially identical. Therefore, only one of the receive paths 220, 230 will be described (i.e., receive path 220). However, it should be noted that each of the receive paths 220, 230 includes a mixer (e.g., mixer 222) that applies a different phase shift to its received signal from the phase shifts applied by mixers in the other receive paths 220, 230. Ultimately, radar processor 240 may determine which receive path 220, 230 produced the strongest signal, and may determine the phase shift between the transmitted and received FMCW signals accordingly (thus indicating the relative velocity of an external object, if one is present, that reflected the FMCW signal with respect to the antenna 204, 206).

Receive path 220 includes mixer 222, one or more amplifiers 224, and continuous-time (CT) sigma delta (ΣΔ) analog-to-digital converter (ADC) 228, in an embodiment. Mixer 222 is configured to mix the incoming FMCW signal from antenna 204 with the FMCW signal produced by the transmit path 210, although a phase shift may be applied to that signal, as discussed above. This process downconverts the received signal to baseband (e.g., to a frequency in a range of about 0 to 5 MHz), with the frequency of the resulting baseband signal indicating the distance between antenna 204 and an external object, if one is present, that reflected the transmitted FMCW signal back toward antenna 204.

The baseband signal may then be amplified by one or more amplifiers 224. For example, the baseband signal may be amplified by a low noise amplifier in order to suppress antenna noise, and a programmable gain amplifier in order to boost the signal for further processing. Only one amplifier 224 is shown in FIG. 2.

In an embodiment, receive path 220 also may include a resistor-capacitor (RC) filter network (NW) 226 at the input of the CT sigma delta ADC 228. RC filter network 226 may provide one or more poles of filtering, in order to further improve the performance of the receive path 220. In an alternate embodiment, RC filter network 226 may be excluded, and all of the filtering may be performed within CT sigma delta ADC 228.

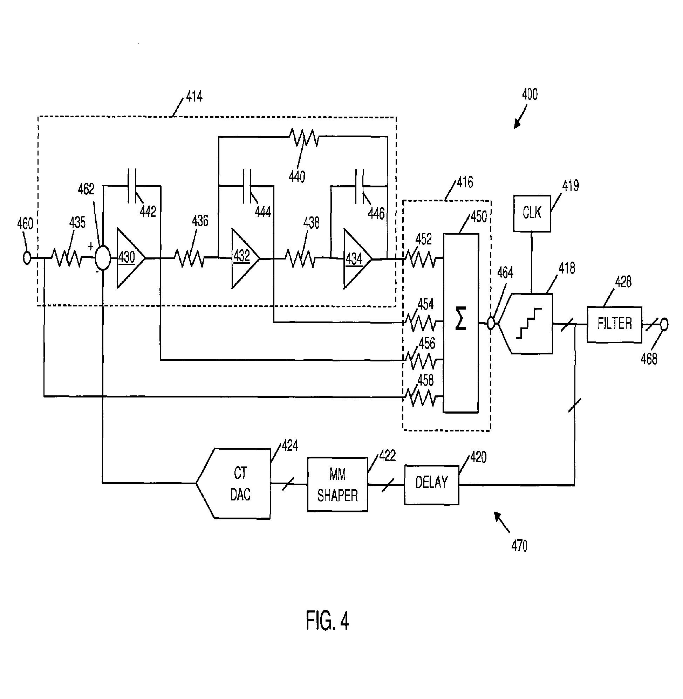

CT sigma delta ADC 228 is configured to filter and digitize the signal produced by RC filter network 226 (or amplifier 224, if RC filter network 226 is excluded), in order to produce a sequence of digital samples representing the amplitudes of the signal at various discrete times. Essentially, CT sigma delta ADC 228 oversamples the signal by a large factor, and filters the oversampled signal to the desired signal band. A digital filter (e.g., decimation filter 328 or 428, FIGs 3, 4) is used to reduce the sampling rate, filter off unwanted noise signal, and increase the resolution of the output. Various embodiments of example sigma delta ADCs are illustrated and described in conjunction with FIGs 3 and 4, later. To avoid redundancy, the various components of the CT sigma delta ADC 228 are not discussed in detail here.

The output signals from receive paths 220, 230 include digital samples, which are received by radar processor 250, in an embodiment. Using techniques that are outside the scope of the present disclosure, radar processor 240 may analyze the digital samples to determine characteristics (e.g., distances and relative velocities) of objects external to the vehicle. Radar processor 240 and/or core(s) 250 may then cause the functioning of other vehicle systems to be altered based on the determined characteristics of the external object(s).

For example, in an embodiment, system 200 may include a collision warning and/or avoidance system, and based on the distances and relative velocities determined by radar module 202, operator interface 290 may be controlled to produce driver warnings. In addition or alternatively, engine/motor controller 296 may be controlled to adjust the output power or other operational characteristics of the vehicle's engine and/or motor. Similarly, braking system 292 and/or steering system 294 may be controlled to appropriately brake the vehicle and/or steer in another direction in order to attempt to avoid an obstacle.

In another example embodiment, system 200 may include an adaptive cruise control system, and based on the distances and relative velocities determined by radar module 202, braking system 292 and/or engine/motor controller 296 may be controlled to vary the speed of the vehicle while it is in a cruise control mode in order to maintain desired distances between the vehicle and other vehicles traveling along the same path. Still other embodiments may include parking assistance systems, blind spot detection systems, lane change assistance systems, and/or backing assistance systems that similarly adjust the operation of various system components based on the distances and relative velocities determined by radar module 202.

Although a particular radar module architecture is depicted in FIG. 2 and described above, those skilled in the art would understand that the various embodiments could be implemented in systems that are differently configured, as well. In addition, in a particular embodiment, module 202 is constructed as part of a single integrated circuit using a conventional complementary metal-oxide semiconductor (CMOS) manufacturing process technology. In another embodiment, module 202 may be made using a different processing technology. Either way, due to the nature of the CT sigma delta ADCs employed in the various embodiments, the components of module 202 may be integrated onto a single integrated circuit. More particularly, because a CT sigma delta ADC produces significantly less noise than a conventional pipeline ADC, the CT sigma delta ADC may be integrated with other components of the vehicle-borne radar system (e.g., with radar processor 240, core(s) 250, flash memory 260, RAM 270, and so on), without a significant risk that the CT sigma delta ADC will unacceptably interfere with the functionality of those other components. Such is not the case with conventional pipeline ADCs, which cannot be integrated with other system components due to their tendency to produce significant quantities of switching noise. According to an embodiment, at least the transmit path 210, receive path(s) 220, 230 (including the clocks associated therewith, such as clocks 319, 419, FIGs 3, 4), and radar processor 240 are integrated onto a single integrated circuit. According to a further embodiment, one or more cores 250, flash memory 260, and/or RAM 270 also may be integrated onto the single integrated circuit.

FIG. 3 is a simplified schematic of a second order CT sigma delta ADC 300 with a feedback topology, which may be used in the system of FIG. 2, according to an example embodiment. ADC 300 includes continuous-time (CT) filter 314, quantizer 318, a clock (CLK) 319, a first feedback path 370, a second feedback path 372, and decimation filter 328. Generally, in operation, ADC 300 receives an analog input signal at input node 360, and in response, provides a plurality of output bits at output node 368, where the output bits are representative of the amplitude of analog input signal at various sampling times. The number of output bits can be any number depending, at least in part, on the desired resolution. In an embodiment, the number of output bits is equal to sixteen. Generally, greater resolution is obtained by increasing the number of bits.

CT filter 314 is configured to suppress quantization noise in ADC 300 within a suppression band (inside the band of interest), so that the signal-to-noise ratio (SNR) of the output of the ADC 300 improves. More particularly, CT filter 314 functions to suppress quantization noise over a frequency range for which the CT filter 314 has the highest gain. For example, CT filter 314 may be configured to suppress quantization noise in a suppression band that extends from a very low frequency (e.g., DC) to an upper frequency limit that is required for ADC 300. In an embodiment, active RC filtering is implemented in CT filter 314 (e.g., using resistors 336, 338, 340 and capacitors 344, 346 in conjunction with amplifiers 332, 334) to provide substantially linear attenuation within the suppression band.

CT filter 314 has a forward path input (at node 360), first and second feedback inputs (at nodes 362, 364), and an output (at node 366). CT filter 314 includes amplifiers 332, 334, resistors 336, 338, 340, and capacitors 344, 346. In the illustrated embodiment, CT filter 314 includes two integration stages, and feedback paths 370, 372 are coupled to CT filter 314 at nodes 362, 364, which are located before each of the integration stages. The number of integration stages defines the number of orders of integration, and accordingly, CT filter 314 is a second order filter. In other embodiments, the number of integration stages (and thus the number of orders of integration) can be higher.

The forward path input of CT filter 314 is connected to an input node 360 for receiving an analog input signal. More specifically, resistor 336 has a first terminal and a second terminal, where the first terminal is connected to the forward path input of CT filter 314 (and thus to input node 360). Amplifier 332 has an input terminal and an output terminal, where the input terminal is connected to the second terminal of resistor 336 and to a first feedback node 362. Capacitor 344 has a first plate electrode connected to the input terminal of amplifier 332, and a second plate electrode connected to the output terminal of amplifier 332. Resistor 338 has a first terminal and a second terminal, where the first terminal is connected to the output terminal of amplifier 332. Amplifier 334 has an input terminal and an output terminal, where the input terminal is connected to the second terminal of resistor 338. Capacitor 346 has a first plate electrode connected to the input terminal of amplifier 334, and a second plate electrode connected to the output terminal of amplifier 334. Resistor 340 has a first terminal and a second terminal, where the first terminal is connected to the input terminal of amplifier 332, and the second terminal connected to the output terminal of amplifier 334.

CT filter 314 produces an analog sample at sampling node 366, which is coupled to quantizer 318. Quantizer 318 has an input coupled to sampling node 366 and a plurality of output terminals. Quantizer 318 is configured to produce a sequence of digital samples (or a quantized, discrete, multi-bit output) based on the input received from CT filter 314 at sampling node 364. According to an embodiment, quantizer 318 is implemented as a multi-bit ADC, and quantizer 318 produces the digital samples at a sample rate that is determined by the frequency of a clock signal provided by clock 319. According to an embodiment, the frequency of the clock signal is in a range of about 200 to about 400 MHz (e.g., about 320 MHz), although higher or lower clock frequencies may be used, as well. The frequency of the clock signal results in the production of an oversampled sequence of digital samples at the output of quantizer 318, and in which the quantization noise is spread over a wider band than it would be if the sampling rate were slower.

The output terminals of quantizer 318 are coupled to decimation filter 328 and to first and second feedback paths 370, 372. First and second feedback paths 370, 372 provide the output of quantizer 318 back to CT filter 314 (at nodes 362, 364), where the fed back signal is subtracted from the signal proceeding along the forward path. This process has a tendency to shape the quantization noise floor, so that the quantization noise is smaller within the band of interest, and larger outside that band. First feedback path 370 includes mismatch (MM) shaper 320 and CT digital-to-analog converter (DAC) 322, in an embodiment. In an alternate embodiment, first feedback path 370 also may include a delay element (e.g., delay element 420, FIG. 4) configured to ensure correct timing between the analog signals received at feedback node 362 along the forward and feedback paths. Second feedback path 372 may include only CT DAC 324, in an embodiment, although second feedback path 372 also may include an MM shaper and/or delay element, as well.

MM shaper 320 includes a digital filter, which is configured to mitigate non-ideal effects of the CT DAC 322. MM shaper 320 has a plurality of input terminals and a plurality of output terminals. The input terminals of MM shaper 320 are connected to the output terminals of quantizer 318.

CT DAC 322 and CT DAC 324 each are configured to convert the digital samples received along feedback paths 370, 372, respectively, into analog signals. According to an embodiment, CT DACs 322, 324 each are implemented using a continuous-time, return-to-zero DAC pulse. CT DACs 322, 324 each have a plurality of input terminals and an output terminal. The input terminals of CT DAC 322 are connected to the output terminals of MM shaper 320, and CT DAC 322 provides a first return-to-zero DAC pulse at its output terminal to node 362. Along the forward path of CT filter 314 at node 362, the first return-to-zero DAC pulse is added to the signal produced at the second terminal of resistor 336, which has the effect of shaping the quantization noise within the system (i.e., to be lower within the band of interest and higher elsewhere). The input terminals of CT DAC 324 are connected to the plurality of output terminals quantizer 318, and CT DAC 324 provides a second return-to-zero DAC pulse at its output terminal to node 364. Along the forward path of CT filter 314 at node 364, the second return-to-zero DAC pulse is added to the signal produced at the second terminal of resistor 338, which has the effect of further shaping the quantization noise.

Decimation filter 328 includes a low pass filter, which is configured to reduce the rate of samples produced by quantizer 3.18, and thus to produce a sequence of digital samples at node 368 that may subsequently be processed (e.g., by radar processor 240, FIG. 2). According to an embodiment, decimation filter 328 reduces the sampling frequency by a factor of about 32 (e.g., resulting in a sampling rate of about 10 MHz, in an embodiment). Decimation filter 328 has a plurality of input terminals and a plurality of output terminals. The input terminals of decimation filter 328 are connected to the output terminals of quantizer 318. A plurality of output bits are provided to output node 368 at the output terminals of decimation filter 328.

FIG. 4 is a simplified schematic of a third order, CT sigma delta ADC 400 with a feed-forward topology, which may be incorporated into the system of FIG. 2, according to an example embodiment. ADC 400 includes CT filter 414, summing circuit 416, quantizer 418, clock 419, feedback path 470, and decimation filter 428. ADC 400 functions similarly to ADC 300 (FIG. 3), in that ADC 400 receives an analog input signal at input node 460, and in response, provides a plurality of output bits at output node 468, where the output bits are representative of the amplitude of analog input signal at various sampling times. To the extent that certain aspects or features of the components of the ADC 400 of FIG. 4 are similar to those of the ADC 300 of FIG. 3, those aspects or features may not be repeated in the discussion of FIG. 4 for the sake of brevity.

CT filter 414 is configured to suppress quantization noise in ADC 400 within a suppression band, so that the SNR of the output of the ADC 400 improves. As with the embodiment depicted in FIG. 3, RC filtering is implemented in CT filter 414 (e.g., using resistors 435, 436, 438, 440 and capacitors 442, 444, 446 in conjunction with amplifiers 430, 432 and 434) to provide substantially linear attenuation.

CT filter 414 has a forward path input (at node 460), a feedback input (at node 462), and first, second, third, and fourth outputs. CT filter 414 includes amplifiers 430, 432, 434, resistors 435, 436, 438, 440, and capacitors 442, 444, 446. In the illustrated embodiment, CT filter 414 includes three integration stages, and feed-forward paths are provided at nodes located before each of the integration stages. For example, a first feed-forward path is shown from a first input terminal of resistor 435 to a first input of summing circuit 416. A second feed-forward path is shown from a first input terminal of resistor 436 to a second input of summing circuit 416. Finally, a third feed-forward path is shown from a first input terminal of resistor 438 to a third input of summing circuit 416. The number of feed-forward paths defines the number of orders of integration, and accordingly, CT filter 414 includes three integration stages, as mentioned above. Although the embodiment of CT filter 414 shown in FIG. 4 includes three feed-forward paths and integration stages (and thus is a third order filter), in other embodiments, the number of feed-forward paths and integration stages (and thus the number of orders of integration) can be higher or lower.

The forward path input of CT filter 414 is connected to an input node 460 for receiving an analog input signal. More specifically, resistor 435 has a first terminal and a second terminal, where the first terminal is connected to the forward path input of CT filter 414 (and thus to input node 460). Amplifier 430 has an input terminal and an output terminal, where the input terminal is connected to the second terminal of resistor 435 and to a feedback node 462. Capacitor 442 has a first plate electrode connected to the input terminal of amplifier 430, and a second plate electrode connected to the output terminal of amplifier 430. Resistor 436 has a first terminal and a second terminal, where the first terminal is connected to the output terminal of amplifier 430. Amplifier 432 has an input terminal and an output terminal, where the input terminal is connected to the second terminal of resistor 436. Capacitor 444 has a first plate electrode connected to the input terminal of amplifier 432, and a second plate electrode connected to the output terminal of amplifier 432. Resistor 438 has a first terminal and a second terminal, where the first terminal is connected to the output terminal of amplifier 432. Amplifier 434 has an input terminal and an output terminal, where the input terminal is connected to the second terminal of resistor 438. Capacitor 446 has a first plate electrode connected to the input terminal of amplifier 434, and a second plate electrode connected to the output terminal of amplifier 434. Resistor 440 has a first terminal and a second terminal, where the first terminal is connected to the input terminal of amplifier 432, and the second terminal connected to the output terminal of amplifier 434.

The outputs of CT filter 414 are coupled to inputs of summing circuit 416. Summing circuit 416 is configured to combine the outputs of CT filter 414 in order to produce an analog sample at sampling node 464. According to an embodiment, summing circuit 416 includes summing element 450 and a plurality of gain elements. In the illustrated embodiment, the gain elements are depicted as resistors 452, 454, 456, and 458. In another embodiment, the gain elements may include different circuit components. In an embodiment, a first output of CT filter 414 is coupled to a first terminal of resistor 458 at a first input of summing circuit 416, a second output of CT filter 414 is coupled to a first terminal of resistor 456 at a second input of summing circuit 416, a third output of CT filter 414 is coupled to a first terminal of resistor 454 at a third input of summing circuit 416, and a fourth output of CT filter 414 is coupled to a first terminal of resistor 452 at a fourth input of summing circuit 416. The second terminals of resistors 452, 454, 456, and 458 are coupled to the inputs of summing element 450. Summing element 450 receives and combines the signals present on the second terminals of resistors 452, 454, 456, 458, in order to produce the analog sample at sampling node 464.

At sampling node 464, the output of summing circuit 416 is coupled to quantizer 418. Quantizer 418 has an input coupled to sampling node 464 and a plurality of output terminals. Quantizer 418 is configured to produce a sequence of digital samples (or a quantized, discrete, multi-bit output) based on the input received from CT filter 414 at sampling node 464. According to an embodiment, quantizer 418 is implemented as a multi-bit ADC, and quantizer 418 produces the digital samples at a sample rate that is determined by the frequency of a clock signal provided by clock 419. According to an embodiment, the frequency of the clock signal is in a range of about 200 to about 400 MHz (e.g., about 320 MHz), although higher or lower clock frequencies may be used, as well. The frequency of the clock signal results in the production of an oversampled sequence of digital samples at the output of quantizer 418, and in which the quantization noise is spread over a wider band than it would be if the sampling rate were slower.

The output terminals of quantizer 418 are coupled to decimation filter 428 and to feedback path 470. Feedback path 470 is configured to provide the output of quantizer 418 back to CT filter 414 (at node 462), where the fed back signal is subtracted from the signal proceeding along the forward path. This process has a tendency to shape the quantization noise floor, so that the quantization noise is smaller within the band of interest, and larger outside that band. Feedback path 470 includes delay element 420, MM shaper 422, and CT DAC 424, in an embodiment. Delay element 420 is configured to ensure correct timing between the analog signals received at feedback node 462 along the forward and feedback paths, and may be excluded in some embodiments. Delay element 420 has a plurality of input terminals and a plurality of output terminals. The input terminals of delay element 420 are connected to the output terminals of quantizer 418.

MM shaper 422 includes a digital filter, which is configured to mitigate non-ideal effects of the CT DAC 424. MM shaper 422 has a plurality of input terminals and a plurality of output terminals. The input terminals of MM shaper 422 are connected to the output terminals of delay element 420.

CT DAC 424 is configured to convert the digital samples received along feedback path 470 into analog signals. According to an embodiment, CT DAC 424 is implemented using a continuous-time, return-to-zero DAC pulse. CT DAC 424 has a plurality of input terminals and an output terminal. The input terminals of CT DAC 424 are connected to the output terminals of MM shaper 422, and CT DAC 424 provides a return-to-zero DAC pulse at its output terminal to node 462. Along the forward path of CT filter 414 at node 462, the return-to-zero DAC pulse is added to the signal produced at the second terminal of resistor 435, which has the effect of shaping the quantization noise within the system (i.e., to be lower within the band of interest and higher elsewhere).

Decimation filter 428 includes a low pass filter, which is configured to reduce the rate of samples produced by quantizer 418, and thus to produce a sequence of digital samples at node 468 that may subsequently be processed (e.g., by radar processor 240, FIG. 2). According to an embodiment, decimation filter 428 reduces the sampling frequency by a factor of about 32 (e.g., resulting in a sampling rate of about 10 MHz, in an embodiment). Decimation filter 428 has a plurality of input terminals and a plurality of output terminals. The input terminals of decimation filter 428 are connected to the output terminals of quantizer 418. A plurality of output bits are provided to output node 468 at the output terminals of decimation filter 428.

Although ADCs 300, 400 are shown with single-ended input and output terminals, one skilled in the art would understand that ADCs 300, 400 can be implemented with differential inputs and/or outputs, and accordingly configurations in which differential inputs and/or outputs are implemented are intended to fall within the scope of the inventive subject matter. In addition, clock signals (not shown) are received and used by various components illustrated in FIGs 3 and 4 to control the analog-to-digital conversion process. Further, although the CT DACs (e.g., CT DACs 322, 424, FIGs 3, 4) included in embodiments of CT sigma delta ADCs discussed herein (e.g., CT sigma delta ADCs 300, 400, FIGs 3, 4) have been described as providing return-to-zero DAC output pulses, one skilled in the art would understand that DACs in other embodiments of CT sigma delta ADCs can be implemented using a variety of other DAC pulse shapes, as well (e.g., non-return-to-zero, switched-capacitor generated pulses, cosine shaped pulses, and so on). Accordingly, CT sigma delta ADCs that include DAC configurations in which other DAC pulse shapes are used are intended to fall within the scope of the inventive subject matter.

Further, although the CT filters (e.g., CT filters 314, 414) depicted in FIGs 3 and 4 may be classified as active RC topologies, one skilled in the art would realize, based on the description herein, that other embodiments may include CT filters implemented using GM/C topologies, passive RC topologies, or various combinations of those topologies. Accordingly, the inventive subject matter is intended to encompass not only the CT filter topologies illustrated in FIGs 3 and 4, but also many other CT filter topologies with various orders for the loop filters, quantization levels, and DAC levels.

FIG. 5 is a flowchart of a method for operating a vehicle-borne system (e.g., system 200, FIG. 2) with a CT sigma delta ADC (e.g., CT sigma delta ADCs 228, 300, 400, FIGs 2-4) in the receive path, according to an example embodiment. As the various method steps depicted in FIG. 5 have been described in more detail above, the below discussion should be considered a summary of the method, and the various embodiment details discussed above apply to the discussion of the method steps of FIG. 5.

The method begins, in block 502, when a transmit path (e.g., transmit path 210, FIG. 2) of a vehicle-borne radar module (e.g., radar module 202, FIG. 2) produces and transmits a signal (e.g., an FMCW signal) in conjunction with one or more antennas (e.g., antennas 204, 206, FIG. 2). In block 504, a reflected version of the transmitted signal may be received (via the one or more antennas) by one or more receive paths (e.g., receive paths 220, 230, FIG. 2) of the vehicle-borne system. Along each receive path, the reflected version of the transmitted signal is downconverted to baseband (e.g., by combining the transmitted and received signals using mixer 222, FIG. 2), amplified (e.g., by amplifier 224, FIG. 2), optionally filtered (e.g., using RC filtering network 226, FIG. 2), and converted to a sequence of digital samples (e.g., using CT sigma delta ADC 228, FIG. 2). According to an embodiment, at least the transmit path and the receive path(s) are integrated onto a same integrated circuit.

In block 506, the sequence of digital samples are processed (e.g., by radar processor 240, FIG. 4) to determine characteristics (e.g., distance and relative velocity) of objects external to the vehicle. Based on the determined characteristics, one or more vehicular functions may be controlled, in block 508 (e.g., by radar processor 240 and/or core 250, FIG. 2). For example, as discussed previously, the vehicle may include any one or more of a collision warning and/or avoidance system, an adaptive cruise control system, a parking assistance system, a blind spot detection system, a lane change assistance system, a backing assistance system, or other systems. The functioning of any one or more of these systems may be altered based on the determined characteristics of the external object(s). For example, the functioning may be altered by producing a warning to the vehicle operator (e.g., via operator interface 290, FIG. 2), altering the operation of an engine and/or motor of the vehicle (e.g., via engine/motor controller 296, FIG. 2), braking the vehicle (e.g., via braking system 292, FIG. 2), adjusting vehicle steering (e.g., via steering system 294, FIG. 2). According to an embodiment, the method may continuously be performed while the vehicle is in an operational state. In other embodiments, the method may be selectively disabled.

It is to be understood that certain ones of the process blocks depicted in FIG. 5 may be performed in parallel with each other or with performing other processes. In addition, it is to be understood that the particular ordering of the process blocks depicted in FIG. 5 may be modified, while achieving substantially the same result. Accordingly, such modifications are intended to be included within the scope of the inventive subject matter. In addition, although particular system configurations are described in conjunction with FIGs 1 and 2, above, embodiments may be implemented in systems having other architectures, as well. These and other variations are intended to be included within the scope of the inventive subject matter.

Thus, various embodiments of vehicle-borne radar systems and methods of their operation have been described. An embodiment of a vehicle-borne radar system includes a transmit path and a first receive path. The transmit path is capable of producing a signal for transmission over an air interface. The receive path includes a CT sigma delta ADC, and the receive path is capable of receiving a reflected version of the signal from the air interface, and converting the reflected version along the receive path into a sequence of digital samples using the CT sigma delta ADC. In an embodiment, the transmit path and the receive path are integrated onto a single integrated circuit.

An embodiment of an automotive system includes one or more antennas, and a radar system coupled to the one or more antennas. The radar system includes a transmit path and a receive path. The transmit path is capable of producing a frequency modulated continuous wave (FMCW) signal for transmission using the one or more antennas. The receive path includes a CT sigma delta ADC, and the receive path is capable of receiving a reflected version of the FMCW signal from the air interface, and converting the reflected version along the receive path into a sequence of digital samples using the CT sigma delta ADC. In an embodiment, the transmit path and the receive path are integrated onto a single integrated circuit.

An embodiment of a method includes producing, by a transmit path incorporated into a vehicle, a signal for transmission over an air interface, and receiving, by a receive path incorporated into the vehicle, a reflected version of the signal from the air interface. The method further includes converting the reflected version along the receive path into a sequence of digital samples using a CT sigma delta ADC.

While the principles of the inventive subject matter have been described above in connection with specific systems, apparatus, and methods, it is to be clearly understood that this description is made only by way of example and not as a limitation on the scope of the inventive subject matter. The various functions or processing blocks discussed herein and illustrated in the Figures may be implemented in hardware, firmware, software or any combination thereof. Further, the phraseology or terminology employed herein is for the purpose of description and not of limitation.

The foregoing description of specific embodiments reveals the general nature of the inventive subject matter sufficiently that others can, by applying current knowledge, readily modify and/or adapt it for various applications without departing from the general concept. Therefore, such adaptations and modifications are within the meaning and range of equivalents of the disclosed embodiments. The inventive subject matter embraces all such alternatives, modifications, equivalents, and variations as fall within the spirit and broad scope of the appended claims.

## Claims

1. A vehicle-borne radar system (202), comprising:
a transmit path (210) capable of producing (502) a signal for transmission over an air interface;
and
a first receive path (220) with a first continuous-time (CT) sigma delta analog-to-digital converter (ADC) (228), wherein the first receive path is capable of receiving (504) a reflected version of the signal from the air interface, and converting the reflected version along the first receive path into a sequence of digital samples using the first CT sigma delta ADC,
wherein the transmit path and the first receive path are integrated onto a single integrated circuit.

2. The system of claim 1, wherein the transmit path (210) is capable of producing (502) the signal as a frequency modulated continuous wave (FMCW) signal.

3. The system of claim 1 or 2, wherein the CT sigma delta ADC (228) comprises a second order CT sigma delta ADC (300).

4. The system of any one of the preceding claims, wherein the CT sigma delta ADC (210) comprises a third order continuous-time, sigma delta converter (400).

5. The system of any one of the preceding claims, wherein the CT sigma delta ADC (210) has a feed-forward topology (400).

6. The system of any one of the preceding claims, wherein the CT sigma delta ADC (210) has a feedback topology (300).

7. The system of any one of the preceding claims, wherein the radar system further comprises:
a clock (319, 419) capable of producing a clock signal having a first frequency in a range of about 200 megahertz to about 400 megahertz, and
wherein the CT sigma delta ADC comprises
a quantizer (318, 418) capable of producing an oversampled sequence of digital samples at the first frequency, and
a decimation filter (328, 428) capable of reducing a rate of samples produced by the quantizer in order to produce the sequence of digital samples.

8. The system of any one of the preceding claims, wherein the receive path further comprises:
a resistor-capacitor filter network (226) coupled to an input of the CT sigma delta ADC, wherein the resistor-capacitor filter network is configured to provide one or more poles of filtering to a signal input to the CT sigma delta ADC.

9. The system of any one of the preceding claims, wherein the transmit path comprises:
a ramp signal generator (212) capable of generating a ramp signal;
a voltage controlled oscillator (214) capable of generating a baseband, frequency modulated signal based on the ramp signal;
an oscillator (218) capable of producing an oscillating signal at a carrier frequency; and
an upconverter (216) capable of upconverting the frequency modulated signal to the signal for transmission.

10. The system of any one of the preceding claims, further comprising:
a processor (240) coupled with the first receive path (220), wherein the processor is capable of determining a distance of an object based on the sequence of digital samples, and
wherein the processor also is integrated onto the single integrated circuit.

11. An automotive system (200), comprising:
one or more antennas (204, 206); and
a radar system (202) coupled to the one or more antennas, wherein the radar system includes
a transmit path (210) capable of producing (502) a frequency modulated continuous wave (FMCW) signal for transmission using the one or more antennas; and
a receive path (220, 230) with a continuous-time (CT) sigma delta analog-to-digital converter (ADC) (228), wherein the receive path is capable of receiving (504) a reflected version of the FMCW signal from the air interface, and converting the reflected version along the receive path into a sequence of digital samples using the CT sigma delta ADC,
wherein the transmit path and the receive path are integrated onto a single integrated circuit.

12. The system of claim 11, further comprising:
a processor (240) coupled with the receive path (220, 230), wherein the processor is capable of determining characteristics of an external object based on the sequence of digital samples, and
wherein the processor also is integrated onto the single integrated circuit.

13. A method comprising:
producing (502), by a transmit path (210) incorporated into a vehicle (100), a signal for transmission over an air interface;
receiving (504), by a receive path (220, 230) incorporated into the vehicle, a reflected version of the signal from the air interface; and
converting (504) the reflected version along the receive path into a sequence of digital samples using a continuous-time (CT) sigma delta analog-to-digital converter (ADC) (228).

14. The method of claim 13, wherein producing (502) the signal for transmission comprises producing a producing a frequency modulated continuous wave (FMCW) signal.

15. The method of claim 13 or 14, further comprising:
processing (506), by a radar processor (240), the sequence of digital samples to determine characteristics of an object external to the vehicle (100).
